# EUROPÄISCHE PATENTSCHRIFT

(11) **EP 0 888 706 B1**
(45) Veröffentlichungstag und Bekanntmachung des Hinweises auf die Patenterteilung: **13.10.1999**
(21) Anmeldenummer: 97915339.2
(22) Anmeldetag: 06.03.1997
(51) Int. Cl.: H05K 7/14

(54) **SPEICHERPROGRAMMIERBARE STEUERUNG**
PROGRAMMABLE CONTROLLER
CONTROLEUR PROGRAMMABLE

(30) Priorität: 18.03.1996 DE 19610559
(43) Veröffentlichungstag der Anmeldung: 07.01.1999
(73) Patentinhaber: SIEMENS AKTIENGESELLSCHAFT, 80333 München (DE)
(72) Erfinder: BURGER, Josef, D-92546 Schmidgaden (DE)
(86) Internationale Anmeldenummer: DE9700437
(87) Internationale Veröffentlichungsnummer: WO9735458

(56) Entgegenhaltungen:
- EP-A- 0 542 594
- EP-A- 0 676 915
- DE-A- 3 603 750
- DE-C- 4 438 801

## Beschreibung

Die vorliegende Erfindung betrifft eine speicherprogrammierbare Steuerung, bestehend aus über einen Rückwandbus miteinander kommunizierenden Baugruppen, die auf einer Montageschiene angeordnet ist, wobei die Baugruppen auf der gleichen Seite der Montageschiene aufgesetzt sind, auf der sich der Rückwandbus befindet, so daß die Baugruppen an der Montageschiene mechanisch gehaltert und mit dem Rückwandbus elektrisch verbunden sind, und die Baugruppen eine direkte Masseverbindung zur Montageschiene aufweisen.

Eine derartige speicherprogrammierbare Steuerung ist beispielsweise aus der EP-A-0 676 915 bekannt.

Bei einer aus DE-A-3 603 750 bekannten speicherprogrammierbaren Steuerung sind einzelne Busmodule auf einer Tragschiene angeordnet, und die Baugruppen der speicherprogrammierbaren Steuerung sind auf die Busmodule aufgeschwenkt.

Die Aufgabe der vorliegenden Erfindung besteht darin, einen Aufbau für eine speicherprogrammierbare Steuerung anzugeben, mittels dessen die Baugruppen der speicherprogrammierbaren Steuerung möglichst störungssicher miteinander kommunizieren können.

Die Aufgabe wird dadurch gelöst,
- daß der Rückwandbus in einer im wesentlichen C-förmigen, elektrisch leitfähigen Montageschiene gelagert ist, so daß der Rückwandbus von der Montageschiene auf drei Seiten umschlossen ist.

Aufgrund des Lagerns des Rückwandbusses in der Montageschiene ist der Rückwandbus bereits auf drei Seiten elektrisch abgeschirmt. Durch das Aufsetzen der Baugruppen ergibt sich dann die Schirmung von der vierten Seite. Die Schirmung ist besonders effektiv, da die Baugruppen über nur einen einzigen Übergangswiderstand, nämlich den zur Montageschiene, mit Masse verbunden sein können.

Wenn der Rückwandbus aus einzelnen, an Grenzflächen aneinander angrenzenden und miteinander verbundenen Busmodulen besteht, kann die Länge des Rückwandbusses den aktuellen Erfordernissen optimal angepaßt werden. Der Rückwandbus steht also nicht an den Seiten des Aufbaus über. Von daher wird die Gefahr der Einkopplung von Störungen noch weiter verringert.

Wenn die Busmodule in der Montageschiene beweglich gelagert sind, können die Busmodule aufgrund ihrer Beweglichkeit Toleranzen ausgleichen.

Wenn die Busmodule an ihren Grenzflächen Rasthaken und Rastausnehmungen aufweisen und die Rasthaken und die Rastausnehmungen benachbarter Busmodule zusammenwirken, können die Busmodule einfach und dennoch sicher miteinander verbunden werden.

Wenn die Rasthaken bei in der Montageschiene gelagerten Busmodulen von der Seite, auf der die Busmodule nicht von der Montageschiene umschlossen ist, zugänglich sind, so daß sie aus den Rastausnehmungen herausdrückbar sind, lassen sich die Busmodule auf besonders einfache Art und Weise voneinander lösen.

Weitere Vorteile und Einzelheiten ergeben sich aus der nachfolgenden Beschreibung eines Ausführungsbeispiels. Dabei zeigen:

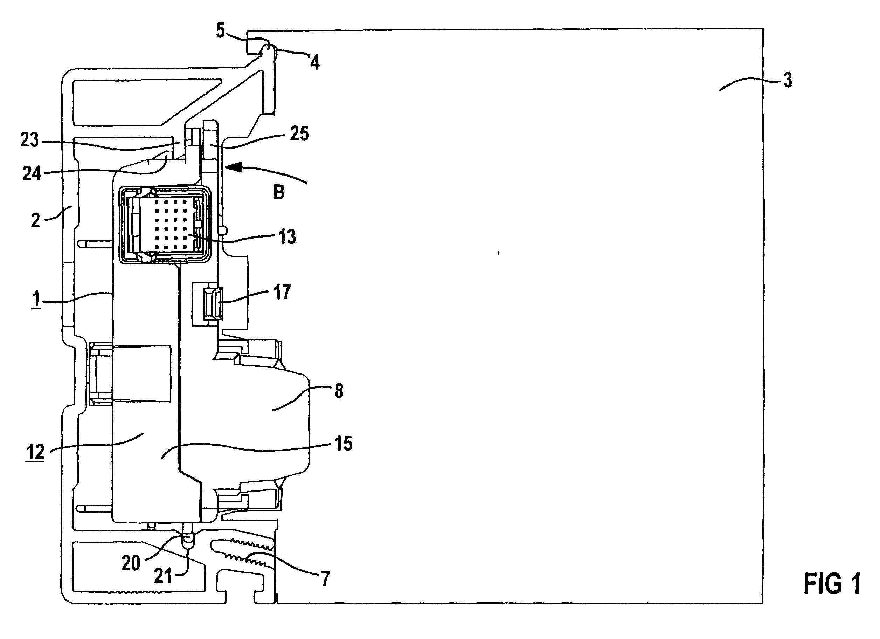

- FIG 1: eine Seitenansicht von Montageschiene, Busmodul und Baugruppe,
- FIG 2: eine perspektivische Sicht von FIG 1 von links unten,
- FIG 3: den gleichen Aufbau von vorne unten,
- FIG 4: den Aufbau von rechts unten,
- FIG 5: eine Explosionsdarstellung des Aufbaus und
- FIG 6: perspektivisch ein Busmodul von unten.

Modulare speicherprogrammierbare Steuerungen bestehen, wie allgemein bekannt, aus einer Stromversorgungsbaugruppe, einer Zentraleinheit und Peripherieeinheiten. Die einzelnen Baugruppen der speicherprogrammierbaren Steuerung kommunizieren über einen Rückwandbus miteinander.

Bei der vorliegenden Erfindung ist der Rückwandbus 1 in einer im wesentlichen C-förmigen Montageschiene 2 gelagert. Die Montageschiene 2 besteht im vorliegenden Fall aus Aluminium oder Stahl. Sie könnte gegebenenfalls mit einem Kunststoffüberzug versehen sein. Alternativ könnte die Montageschiene 2 auch aus einem Kunststoff bestehen, der mit einem metallischen Überzug versehen ist. Durch die Lagerung des Rückwandbusses 1 in der Montageschiene 2 ist der Rückwandbus 1 von vorneherein auf drei Seiten von der Montageschiene 2 umschlossen, so daß der Rückwandbus 1 von drei Seiten vor elektrischer Einstrahlung abgeschirmt ist.

Die Baugruppen 3 werden mit dem Rückwandbus 1 und der Montageschiene 2 dadurch verbunden, daß sie zunächst mit einer Schwenknut 4 in einen Vorsprung 5 eingesetzt und dann auf die Montageschiene 2 und den Rückwandbus 1 aufgeschwenkt werden. Nach dem Aufschwenken werden sie durch eine Schraube 6, welche in die geriffelte Nut 7 der Montageschiene 2 eingedreht wird, endgültig gesichert. Die Baugruppen 3 sind dadurch also an der Montageschiene 2 mechanisch gehaltert. Ferner kontaktieren beim Aufschwenken der Baugruppen 3 die Baugruppen 3 mit den Kontaktsätzen 8 des Rückwandbusses 1, so daß die Baugruppen 3 mit dem Rückwandbus 1 auch elektrisch verbunden sind.

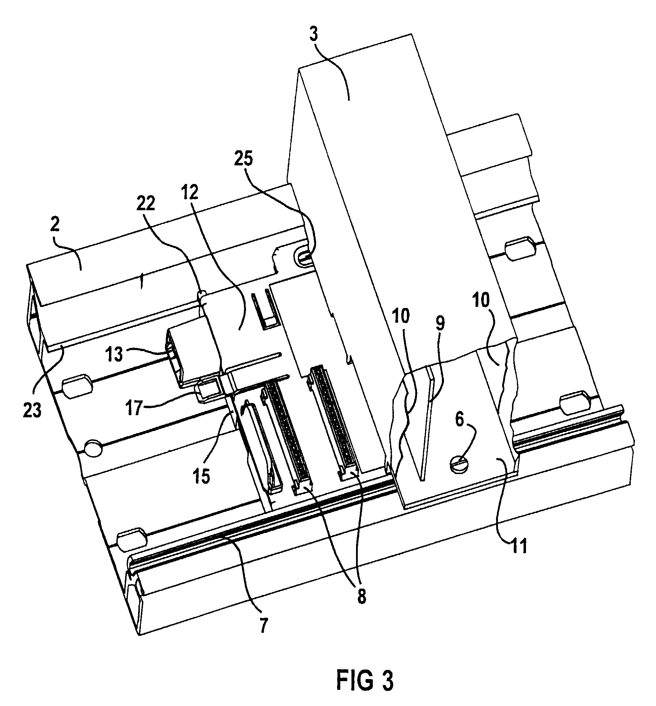

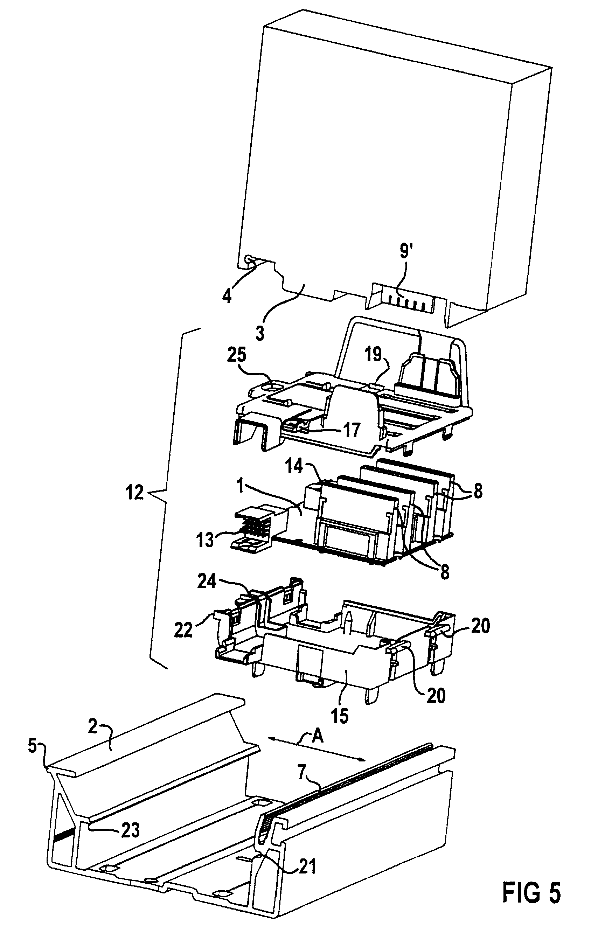

Wie insbesondere aus FIG 3 ersichtlich ist, weisen die Baugruppen 3 eine Leiterplatte 9 auf, auf der eine elektrische/ elektronische Schaltung angeordnet ist. Die Leiterplatte 9 ist - siehe insbesondere FIG 5 - mit ihren Kontaktstellen 9' in einen der Kontaktsätze 8 einsteckbar. Zur Schirmung dieser Schaltung weist die Leiterplatte Schirmbleche 10 auf. Wie ebenfalls aus FIG 3 ersichtlich ist, sind die Schirmbleche 10 durch ein Querblech 11 miteinander verbunden. Vorzugsweise sind die Schirmbleche 10 und das Querblech 11 als einstückige Einheit ausgebildet, z.B. in Form eines Stanzbiegeteils.

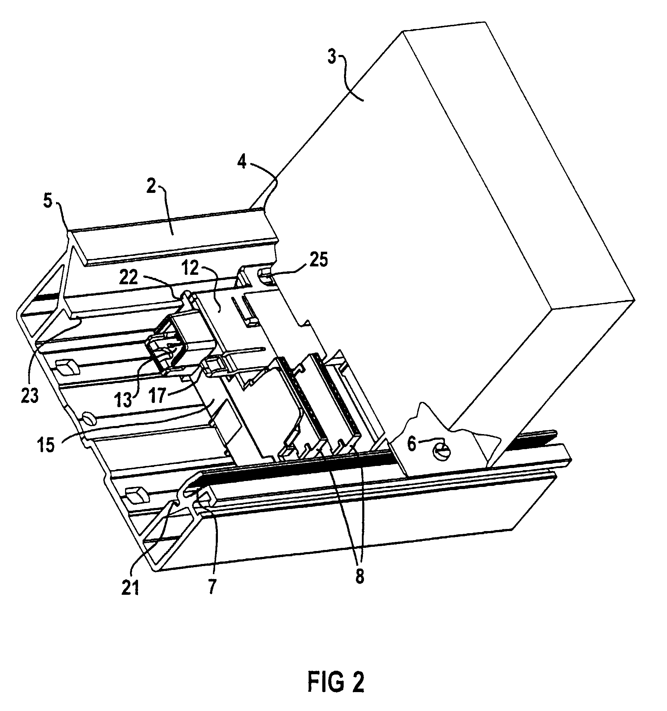

Wie aus den FIG 2 und 3 ersichtlich ist, durchquert die Schraube 6 das Querblech 11. Dadurch liegt die Schraube 6 im festgeschraubten Zustand am Querblech 11 an, und das Gewinde der Schraube 6 kontaktiert die geriffelte Nut 7. Die Baugruppen weisen somit eine direkte Masseverbindung zur Montageschiene 2 auf. Der Rückwandbus ist daher auch auf seiner vierten Seite abgeschirmt.

Alternativ oder zusätzlich könnte das Querblech 11 auch auf der Rückseite der Baugruppe 3 nach außen geführt sein, so daß sich ein direkter Kontakt des Querblechs 11 mit der Montageschiene 2 ergibt.

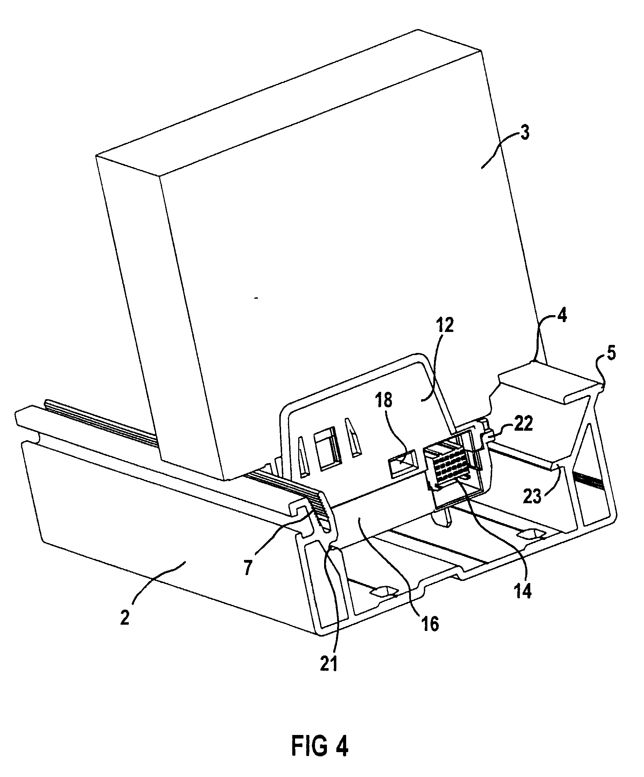

Wie aus den FIG 2 bis 5 ersichtlich ist, besteht der Rückwandbus 1 aus einzelnen Busmodulen 12, welche über miteinander korrespondierende Steckverbinder 13,14 elektrisch miteinander verbindbar sind, so daß die Busmodule 12 bei ineinander gesteckten Steckverbindern 13,14 mit ihren Grenzflächen 15,16 aneinander angrenzen.

Zur besseren mechanischen Stabilität der Verbindung weisen die Busmodule 12 an ihren Grenzflächen 15 Rasthaken 17 auf, welche mit korrespondierenden Rastausnehmungen 18 an den Grenzflächen 16 benachbarter Busmodule 12 zusammenwirken.

Beim Zusammenfügen der Busmodule 12 verrasten die Rasthaken 17 selbsttätig in den Rastausnehmungen 18 des jeweils benachbarten Busmoduls 12. Die Busmodule 12 sind daher ohne Werkzeug nicht mehr voneinander trennbar. Um die Busmodule 12 wieder voneinander trennen zu können, weisen die Busmodule 12 auf ihrer Frontseite, die den Baugruppen 3 zugewandt ist, eine Ausnehmung 19 auf. Durch diese Ausnehmung 19 hindurch ist der korrespondierende Rasthaken 17 mittels eines Schraubendrehers oder eines ähnlichen Werkzeugs zugänglich. Dadurch können die Rasthaken 17 wieder aus den Rastausnehmungen 18 herausgedrückt werden. Die Ausnehmung 19 ist insbesondere aus FIG 5 ersichtlich.

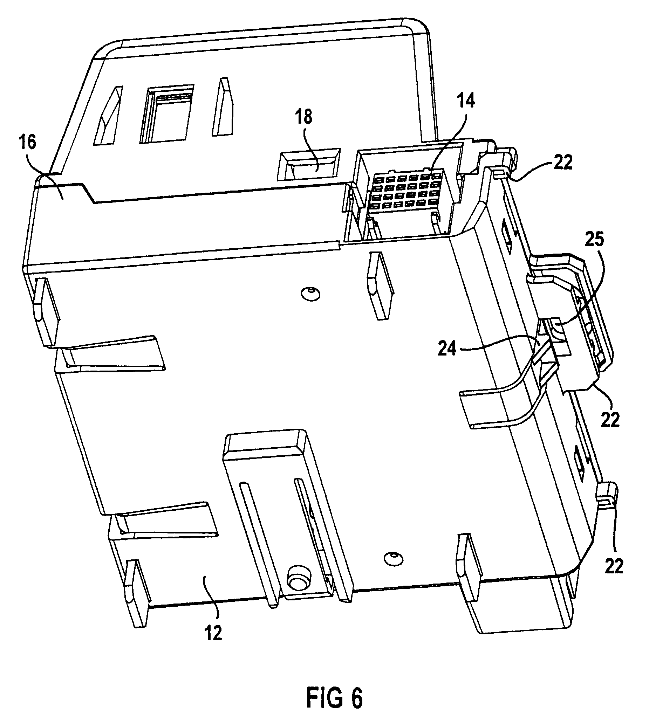

Gemäß dem Ausführungsbeispiel werden zur Montage eines Busmoduls 12 in der Montageschiene 2 zunächst die Stege 20 des Busmoduls 12 in die Nut 21 der Montageschiene 2 eingesetzt. Sodann wird das Busmodul 12 in Richtung des Pfeils B in die Montageschiene 2 eingeschwenkt, bis die Gegenlager 22 des Busmoduls 12 auf dem Steg 23 der Montageschiene 2 aufsetzen. Kurz zuvor hintergreift der Rasthaken 24 (siehe insbesondere FIG 6) den Steg 23, so daß das Busmodul 12 in der Montageschiene 2 mechanisch gehalten ist. Der Rasthaken 24 kann durch Ansetzen eines Schraubendrehers durch die Ausnehmung 25 ausgedrückt werden, so daß das Busmodul 12 dann wieder von der Montageschiene 2 lösbar ist.

Alternativ können die Busmodule 12 auch nur in die Montageschiene 2 eingelegt sein. In jedem Fall aber sind die Busmodule 12 in der Montageschiene 2 in Richtung des Doppelpfeils A (siehe FIG 5) beweglich gelagert. Dies hat den Vorteil, daß die Busmodule 12 Toleranzen der Baugruppen 3, welche ansonsten zu unzulässigen mechanischen Beanspruchungen führen würden, ausgleichen können.

In den FIG ist nur ein Busmodul 12 dargestellt, das mit nur einer Baugruppe 3 bestückt ist. Es ist aber selbstverständlich, daß mehrere Busmodule 12 vorhanden sein können und daß jedes Busmodul 12 mit mehr als einer Baugruppe 3 bestückt ist.

## Patentansprüche

1. Speicherprogrammierbare Steuerung, bestehend aus über einen Rückwandbus (1) miteinander kommunizierenden Baugruppen (3), die auf einer Montageschiene angeordnet ist,
- wobei der Rückwandbus (1) in einer im wesentlichen C-förmigen, elektrisch leitfähigen Montageschiene (2) gelagert ist, so daß der Rückwandbus (1) von der Montageschiene (2) auf drei Seiten umschlossen ist,
- wobei die Baugruppen (3) auf der gleichen Seite der Montageschiene (2) aufgesetzt sind, auf der sich der Rückwanbus befindet, so daß die Baugruppen (3) an der Montageschiene (2) mechanisch gehaltert und mit dem Rückwandbus (1) elektrisch verbunden sind,
- wobei die Baugruppen (3) eine direkte Masseverbindung zur Montageschiene (2) aufweisen.

2. Speicherprogrammierbare Steuerung nach Anspruch 1, **dadurch gekennzeichnet, daß** der Rückwandbus (1) aus einzelnen, an Grenzflächen (15,16) aneinander angrenzenden und miteinander verbundenen Busmodulen (12) besteht.

3. Speicherprogrammierbare Steuerung nach Anspruch 2, **dadurch gekennzeichnet, daß** die Busmodule (12) in der Montageschiene (2) beweglich gelagert sind.

4. Speicherprogrammierbare Steuerung nach Anspruch 2 oder 3, **dadurch gekennzeichnet, daß** die Busmodule (12) in der Montageschiene (2) verrastet sind.

5. Speicherprogrammierbare Steuerung nach Anspruch 2, 3 oder 4, **dadurch gekennzeichnet, daß** die Busmodule (12) an ihren Grenzflächen (15,16) Rasthaken (17) und Rastausnehmungen (18) aufweisen und daß die Rasthaken (17) und die Rastausnehmungen (18) benachbarter Busmodule (12) zusammenwirken.

6. Speicherprogrammierbare Steuerung nach Anspruch 5, **dadurch gekennzeichnet, daß** die Rasthaken (17) bei in der Montageschiene (2) gelagerten Busmodulen (12) von der Seite, auf der die Busmodule (12) nicht von der Montageschiene (2) umschlossen ist, zugänglich sind, so daß sie aus den Rastausnehmungen (18) herausdrückbar sind.

## Claims

1. Programmable logic controller, comprising assemblies (3) which communicate with one another via a backplane bus (1), which is arranged on a mounting rail,
- the backplane bus (1) being mounted in an essentially C-shaped, electrically conductive mounting rail (2), with the result that the backplane bus (1) is enclosed by the mounting rail (2) on three sides,
- the assemblies (3) being placed on the same side of the mounting rail (2) on which the backplane bus is located, with the result that the assemblies (3) are mechanically retained on the mounting rail (2) and are electrically connected to the backplane bus (1),
- the assemblies (3) having a direct earth connection to the mounting rail (2).

2. Programmable logic controller according to Claim 1, characterized in that the backplane bus (1) comprises individual bus modules (12) which adjoin one another at boundary surfaces (15, 16) and are connected to one another.

3. Programmable logic controller according to Claim 2, characterized in that the bus modules (12) are mounted such that they can move in the mounting rail (2).

4. Programmable logic controller according to Claim 2 or 3, characterized in that the bus modules (12) are latched in the mounting rail (2).

5. Programmable logic controller according to Claim 2, 3 or 4, characterized in that the bus modules (12) have latching hooks (17) and latching recesses (18) on their boundary surfaces (15, 16), and in that the latching hooks (17) and the latching recesses (18) of neighbouring bus modules (12) interact.

6. Programmable logic controller according to Claim 5, characterized in that, when the bus modules (12) are mounted in the mounting rail (2), the latching hooks (17) are accessible from the side on which the bus modules (12) are not enclosed by the mounting rail (2), with the result that they can be pressed out of the latching recesses (18).

## Revendications

1. Commande programmable disposée sur un rail de montage et constituée de groupes de composants (3) en communication mutuelle par l'intermédiaire d'une barre omnibus (1) montée sur un panneau postérieur,
- la barre omnibus postérieure (1) étant logée dans un rail de montage (2) électriquement conducteur, pour l'essentiel configuré en C, de sorte que la barre omnibus postérieure (1) est entourée sur trois côtés par le rail de montage (2),
- les groupes de composants (3) étant mis en place, sur le rail de montage (2), du même côté que celui sur lequel la barre omnibus postérieure est disposée, si bien que les groupes de composants (3) sont retenus mécaniquement sur le rail de montage (2), et sont raccordés électriquement à la barre omnibus postérieure (1),
- les groupes de composants (3) présentant une liaison directe à la masse par rapport au rail de montage (2).

2. Commande programmable selon la revendication 1,
caractérisée par le fait que la barre omnibus postérieure (1) se compose de modules omnibus (12) individuels, reliés mutuellement et réciproquement adjacents sur des surfaces de délimitation (15, 16).

3. Commande programmable selon la revendication 2,
caractérisée par le fait que les modules omnibus (12) sont logés avec mobilité dans le rail de montage (2).

4. Commande programmable selon la revendication 2 ou 3,
caractérisée par le fait que les modules omnibus (12) sont encliquetés dans le rail de montage (2).

5. Commande programmable selon la revendication 2, 3 ou 4,
caractérisée par le fait que les modules omnibus (12) comportent des crochets encliquetables (17) et des évidements d'encliquetage (18) sur leurs surfaces de délimitation (15, 16) ; et par le fait que les crochets encliquetables (17) et les évidements d'encliquetage (18) de modules omnibus (12) voisins coopèrent les uns avec les autres.

6. Commande programmable selon la revendication 5,
caractérisée par le fait que, lorsque les modules omnibus (12) sont logés dans le rail de montage (2), les crochets encliquetables (17) sont accessibles à partir du côté sur lequel les modules omnibus (12) ne sont pas entourés par le rail de montage (2), de sorte que les crochets peuvent être extraits des évidements d'encliquetage (18).
